# EUROPEAN PATENT APPLICATION

(11) **EP 4 709 101 A1**
(43) Date of publication of application: **11.03.2026**
(21) Application number: 25796651.5
(22) Date of filing: 22.01.2025
(51) Int. Cl.: H10F 77/14, H10F 77/70

(54) **SOLAR CELL, CELL ASSEMBLY AND PHOTOVOLTAIC SYSTEM**

(30) Priority: 15.07.2024 CN 202410950720
(71) Applicant: Zhejiang Aiko Solar Energy Technology Co., Ltd., Jinhua, Zhejiang 322000 (CN); Zhuhai Fushan Aiko Solar Energy Technology Co., Ltd., Zhuhai, Guangdong 519000 (CN); Chuzhou Aiko Solar Technology Co., Ltd., Chuzhou, Anhui 239514 (CN); Shenzhen Aiko Digital Energy Technology Co., Ltd., Shenzhen, Guangdong 518000 (CN); Tianjin Aiko Solar Energy Technology Co., Ltd., Tianjin 300400 (CN); Guangdong Aiko Solar Energy Technology Co., Ltd., Foshan, Guangdong 528000 (CN)
(72) Inventor: WANG, Yongqian, Jinhua, Zhejiang 322000 (CN); CHEN, Hui, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2025/074091
(87) International publication number: WO 2026/016445

(57) **Abstract**

The present disclosure is applicable to the field of photovoltaic technology, and provides a solar cell, a cell assembly, and a photovoltaic system. The solar cell includes: a silicon substrate, which includes a first region, where the first region is provided with a plurality of first tower base structures and a plurality of second tower base structures, with at least some of the second tower base structures arranged on the first tower base structures. The composite arrangement of the first tower base structures and the second tower base structures increases the complexity of the surface morphology of the first region, and can significantly enhance the photoelectric conversion efficiency and mechanical strength of the solar cell.

## Description

### Cross-Reference to Related Application

The present disclosure claims priority to Chinese Patent Application No. 202410950720.8, filed with the China National Intellectual Property Administration on July 15, 2024, and entitled "SOLAR CELL, CELL ASSEMBLY, AND PHOTOVOLTAIC SYSTEM", which is incorporated herein by reference in its entirety.

### Technical Field

The present disclosure belongs to the field of photovoltaic technology, and in particular, to a solar cell, a cell assembly, and a photovoltaic system.

### Background

The photoelectric conversion efficiency and mechanical strength of solar cells are two critical performance indicators. On one hand, the characteristic sizes of existing textured surface structures that are too large or too small have a certain negative impact on subsequent film passivation and paste contact interfaces, which in turn affects the cell performance.

On the other hand, conventional silicon wafers are prone to stress concentration during manufacturing and use, and especially when growing polycrystalline silicon films at a high temperature, the stress concentration will lead to silicon wafer bowing. In the process of automatic production and delivery of the silicon wafers, the silicon wafers are susceptible to mechanical damages such as hidden cracks, chipping, scratching, and edge collapse due to stress, affecting product yield and reliability.

### Summary

The present disclosure provides a solar cell, a cell assembly, and a photovoltaic system, and aims to solve the problems that in the prior art, significant defects exist in the aspect of mechanical performance, the photoelectric conversion efficiency is low, and product reliability is poor.

The present disclosure is implemented in this way. A solar cell includes:
a silicon substrate, which includes a first region,
the first region being provided with a plurality of first tower base structures and a plurality of second tower base structures, with at least some of the second tower base structures arranged on the first tower base structures.

In some embodiments, a longest diagonal length of the first tower base structures is greater than or equal to 2 µm and less than or equal to 60 µm.

In some embodiments, the longest diagonal length of the first tower base structures is greater than or equal to 5 µm and less than or equal to 40 µm.

In some embodiments, the longest diagonal length of the first tower base structures is greater than or equal to 10 µm and less than or equal to 30 µm.

In some embodiments, the longest diagonal length of the first tower base structures is greater than or equal to 15 µm and less than or equal to 30 µm.

In some embodiments, a longest diagonal length of the second tower base structures is greater than or equal to 0.5 µm and less than or equal to 30 µm.

In some embodiments, the longest diagonal length of the second tower base structures is greater than or equal to 1 µm and less than or equal to 30 µm.

In some embodiments, the longest diagonal length of the second tower base structures is greater than or equal to 1 µm and less than or equal to 20 µm.

In some embodiments, the longest diagonal length of the second tower base structures is greater than or equal to 5 µm and less than or equal to 20 µm.

In some embodiments, a ratio of a total area of orthographic projections of the second tower base structures on the first region to an area of the first region is greater than 60%.

In some embodiments, a second region is further included, and the second region and the first region are located on a same side of the silicon substrate or on two opposite sides of the silicon substrate.

In some embodiments, the second region is provided with a plurality of third tower base structures.

In some embodiments, a longest diagonal length of the third tower base structures is greater than or equal to 2 µm and less than or equal to 60 µm.

In some embodiments, the longest diagonal length of the third tower base structures is greater than or equal to 5 µm and less than or equal to 40 µm.

In some embodiments, the longest diagonal length of the third tower base structures is greater than or equal to 10 µm and less than or equal to 30 µm.

In some embodiments, the longest diagonal length of the third tower base structures is greater than or equal to 15 µm and less than or equal to 30 µm.

In some embodiments, a longest diagonal length of the first tower base structures is greater than a longest diagonal length of the second tower base structures.

In some embodiments, a ratio of the longest diagonal length of the first tower base structures to a longest diagonal length of the third tower base structures ranges from 0.5 to 2.

In some embodiments, a roughness of the first region is greater than a roughness of the second region.

In some embodiments, the plurality of first tower base structures are in a linear array.

In some embodiments, the plurality of third tower base structures are in a linear array.

In some embodiments, the first tower base structures are downward concave structures, or the second tower base structures are downward concave structures, or wherein the first tower base structures and the second tower base structures are downward concave structures.

In some embodiments, a depth of downward concavity of the first tower base structures is greater than or equal to 0.05 µm and less than or equal to 2 µm, or a depth of downward concavity of the second tower base structures is greater than or equal to 0.05 µm and less than or equal to 2 µm, or a depth of downward concavity of the first tower base structures and a depth of downward concavity of the second tower base structures are greater than or equal to 0.05 µm and less than or equal to 2 µm.

In some embodiments, the third tower base structures are downward concave structures.

In some embodiments, a depth of downward concavity of the third tower base structures is greater than or equal to 0.05 µm and less than or equal to 1.5 µm.

The present disclosure further provides a cell assembly, including the above solar cell.

The present disclosure further provides a photovoltaic system, including the above cell assembly.

The present disclosure has the beneficial effects that the composite arrangement of the first tower base structures and the second tower base structures increases the complexity of the surface morphology of the first region, and can enhance the photoelectric response and mechanical strength of the solar cell.

### Brief Description of the Drawings

Fig. 1 is a scanning electron micrograph of a first region of a solar cell at a magnification of 1k according to the present disclosure;
Fig. 2 is a scanning electron micrograph of first tower base structures of the solar cell at a first angle according to the present disclosure;
Fig. 3 is a scanning electron micrograph of the first tower base structures of the solar cell at a second angle according to the present disclosure;
Fig. 4 is a scanning electron micrograph of the first tower base structures of the solar cell at a third angle according to the present disclosure;
Fig. 5 is a scanning electron micrograph of a second region of the solar cell at a magnification of 1k according to the present disclosure;
Fig. 6 is a scanning electron micrograph of third tower base structures of the solar cell at a first angle according to the present disclosure; and
Fig. 7 is a scanning electron micrograph of the third tower base structures of the solar cell at a third angle according to the present disclosure.

### Descriptions of reference numerals:

101-first tower base structure; 102-second tower base structure; and 103-third tower base structure.

### Detailed Description of the Embodiments

In order to provide a clearer understanding of the objectives, technical solutions, and advantages of the present disclosure, the present disclosure is further described in detail in conjunction with accompanying drawings and embodiments below. Examples of the embodiments are shown in accompanying drawings, where the same or similar elements or the elements having the same or similar functions are denoted by the same or similar reference numerals throughout the description. The embodiments described below with reference to the accompanying drawings are exemplary, are used only for explaining the present disclosure, and should not be construed as a limitation on the present disclosure. Additionally, it should be understood that the specific embodiments described herein are merely used for explaining the present disclosure rather than limiting the present disclosure.

In the description of the present disclosure, it should be understood that orientation or position relationships indicated by the terms such as "length", "width", "upper", "lower", "left", "right", "horizontal", "top", and "bottom", are based on orientation or position relationships shown in the accompanying drawings, and are intended to facilitate the description of the present disclosure and simplify the description only, rather than indicate or imply that an apparatus or element referred needs to have a particular orientation or be constructed and operated in a particular orientation. Therefore, such terms should not be construed as limiting the present disclosure.

Additionally, the terms "first" and "second" are used merely for the purpose of description, and should not be construed as indicating or implying relative importance or implying a quantity of indicated technical features. Therefore, features defined as "first" and "second" may explicitly or implicitly include one or more of the features. In the descriptions of the present disclosure, unless otherwise explicitly limited, "a plurality of" means two or more than two.

In the description of the present disclosure, it should be noted that the terms "mounted", "connected", and "linked" should be understood in a broad sense, unless otherwise explicitly specified or defined. For example, it may be a fixed connection, a detachable connection, or an integrated connection; it may be a mechanical connection, an electrical connection, or a mutual communication; or it may be a direct connection, an indirect connection through an intermediate medium, a communication between interiors of two elements, or an interaction relationship between the two elements. Those of ordinary skill in the art may understand the specific meanings of the foregoing terms in the present disclosure according to specific situations.

In the present disclosure, unless otherwise expressly specified and limited, a first feature being "above" or "below" a second feature may include direct contact between the first feature and the second feature, or may also include indirect contact between the first feature and the second feature through an additional feature therebetween. In addition, the first feature being "over", "above", and "on" the second feature includes the first feature being over and above the second feature, or merely indicates that a level of the first feature is higher than that of the second feature. The first feature being "under", "below", and "underneath" the second feature includes the first feature being under and below the second feature, or merely indicates that the level of the first feature is lower than that of the second feature.

The following disclosure provides multiple different embodiments or examples to implement different structures of the present disclosure. To simplify the disclosure of the present disclosure, components and settings in particular examples are described below. Certainly, they are merely examples and are not intended to limit the present disclosure. Further, in the present disclosure, reference numerals and/or reference letters may be repeated in different examples, and such repetition is for simplification and clarity purposes and does not indicate a relationship between the various embodiments and/or settings being discussed. In addition, the present disclosure provides examples of various specific processes and materials, but those of ordinary skill in the art can realize the application of other processes and/or the use of other materials.

According to the present disclosure, a first tower base structure and a second tower base structure are compositely arranged, which increases the complexity of the surface morphology of a first region, thereby enhancing the photovoltaic response and mechanical strength of a solar cell.

### Embodiment 1

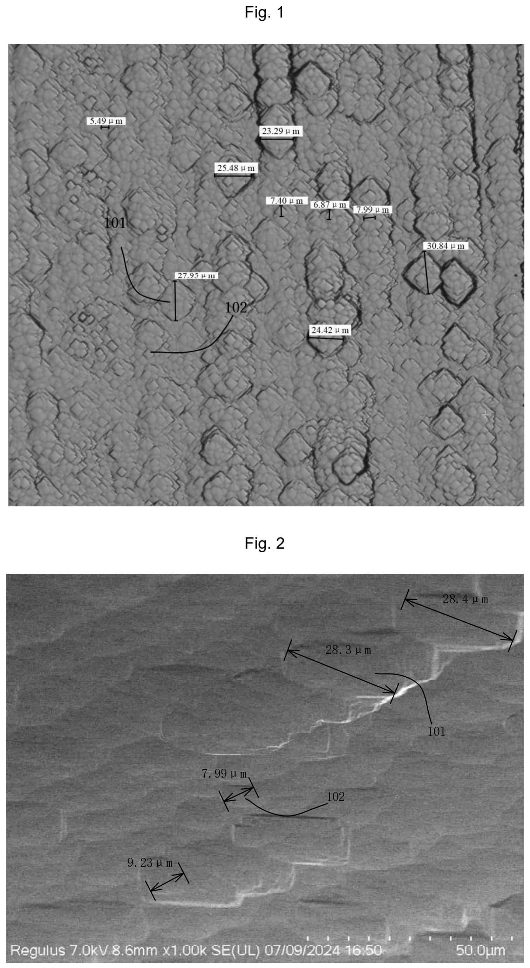

As shown in Fig. 1 to Fig. 3, this embodiment provides a solar cell, including:
a silicon substrate, which includes a first region,
where the first region is provided with a plurality of first tower base structures 101 and a plurality of second tower base structures 102, with at least some of the second tower base structures 102 arranged on the first tower base structures 101.

The tower base structures refer to microstructures arranged on the silicon substrate of the solar cell. These microstructures typically appear in the form of towers or cones, with a flat top surface and a polygonal outer contour, specifically including at least one of a diamond shape, a square, a trapezoid, an approximate diamond shape, an approximate square, and an approximate trapezoid. The first tower base structures 101 and the second tower base structures 102 are formed on the first region of the silicon substrate through a certain process method, with at least some of the second tower base structures 102 located on tops of the first tower base structures 101.

The composite existence of the first tower base structures 101 and the second tower base structures 102 may be specifically the parallel arrangement of the second tower base structures 102 and the first tower base structures 101, or the second tower base structures 102 being arranged on top surfaces of the first tower base structures 101. The arrangement method provides a more complex surface morphology, which facilitates the deposition and formation of subsequent films on the silicon substrate.

Due to the composite existence of the first tower base structures 101 and the second tower base structures 102, the complexity of the surface morphology of the first region is increased. The existence of the first tower base structures 101 and the second tower base structures 102 causes multiple reflections and scattering of incident light on a surface of the silicon substrate, thereby increasing an optical path of the light within the silicon substrate. Especially, back-surface diffuse reflected light undergoes multiple reflections through the structures of the first tower base structures 101 and the second tower base structures 102, so as to be more effectively absorbed by the silicon substrate. As the optical path increases, a travel path of photons within the silicon substrate becomes longer, thereby increasing the probability of absorption, and then enhancing the photoelectric response of the solar cell.

Composite textures of the first tower base structures 101 and the second tower base structures 102 can also provide superior surface features, thereby allowing screen-printed metal paste to better fill spaces between the tower base structures when forming electrodes. The improved contact feature reduces the contact resistance between the electrode and the silicon substrate, thereby enhancing an open-circuit voltage and a fill factor of the cell.

Structurally, the composite arrangement of the first tower base structures 101 and the second tower base structures 102 facilitates in dispersing and releasing the stress generated during the growth of a polycrystalline silicon film on a silicon wafer under a high-temperature condition. The stacking of the first tower base structures 101 and the second tower base structures 102 may provide multi-level stress release paths, thereby reducing stress concentration phenomena. By optimizing the shape and distribution of the tower base structures, the overall stress on the silicon wafer can be effectively reduced, thereby reducing a bowing degree under the high-temperature condition. The improved stress distribution and the reduced silicon wafer curvature make the silicon wafer less prone to mechanical damages such as chipping, scratching, and edge collapse in the process of automatic production and delivery of the silicon wafer, thereby improving production efficiency and product quality.

In this embodiment, by arranging the first tower base structures 101 and the second tower base structures 102 on the silicon substrate, the photoelectric response and mechanical strength of the solar cell can be enhanced.

### Embodiment 2

Based on Embodiment 1, the longest diagonal length of the first tower base structures 101 is greater than or equal to 2 µm and less than or equal to 60 µm.

Since a top surface of a tower base is typically polygonal, a longest diagonal line refers to a diagonal line with the maximum length. Experimental verifications show that the shape of the top surface of the tower base is not excessively elongated. Generally, the longer the longest diagonal line, the larger the area of the top surface of the tower base.

When the longest diagonal length of the tower base is measured, a film surface can be directly measured for calibration through test instruments such as an optical microscope, an atomic force microscope, a scanning electron microscope, and a transmission electron microscope.

By further limiting the longest diagonal size of the first tower base structures 101, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 3

Based on Embodiment 1, the longest diagonal length of the first tower base structures 101 is greater than or equal to 5 µm and less than or equal to 40 µm.

By further limiting the longest diagonal size of the first tower base structures 101, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 4

Based on Embodiment 1, the longest diagonal length of the first tower base structures 101 is greater than or equal to 10 µm and less than or equal to 30 µm.

By further limiting the longest diagonal size of the first tower base structures 101, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 5

Based on Embodiment 1, the longest diagonal length of the first tower base structures 101 is greater than or equal to 15 µm and less than or equal to 30 µm.

By further limiting the longest diagonal size of the first tower base structures 101, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 6

Based on Embodiment 1, the longest diagonal length of the second tower base structures 102 is greater than or equal to 0.5 µm and less than or equal to 30 µm.

By further limiting the longest diagonal size of the second tower base structures 102, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 7

Based on Embodiment 1, the longest diagonal length of the second tower base structures 102 is greater than or equal to 1 µm and less than or equal to 30 µm.

By further limiting the longest diagonal size of the second tower base structures 102, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 8

Based on Embodiment 1, the longest diagonal length of the second tower base structures 102 is greater than or equal to 1 µm and less than or equal to 20 µm.

By further limiting the longest diagonal size of the second tower base structures 102, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 9

Based on Embodiment 1, the longest diagonal length of the second tower base structures 102 is greater than or equal to 5 µm and less than or equal to 20 µm.

By further limiting the longest diagonal size of the second tower base structures 102, the tower base structures are optimized. The optimized tower base structures can not only effectively release stress and reduce mechanical damages but also further improve the passivation quality and electrode contact characteristics in the first region, thereby enhancing the open-circuit voltage and the fill factor, and finally improving the overall conversion efficiency of the cell.

### Embodiment 10

Based on any one of the embodiments from Embodiment 5 to Embodiment 10, a total area of the plurality of second tower base structures 102 accounts for more than 60% of an area of the first region.

Embodiments 5 to 10 further define the longest diagonal length of the second tower base structures 102. It is not necessary for all the second tower base structures 102 within the first region to meet defined sizes; and it is sufficient that the sum of the areas of all the second tower base structures 102 that meet the defined sizes is greater than 60% of the total area of the first region. Specifically, if the total area of the first region is A, the sum of the areas of all the second tower base structures 102 that meet the defined sizes is greater than 0.6A, thereby ensuring the sufficiently extensive coverage of the second tower base structures 102 within the first region, to achieve desired optimization effects.

### Embodiment 11

Based on Embodiment 1, the solar cell further includes a second region, and the second region and the first region are located on the same side of the silicon substrate or on two opposite sides of the silicon substrate.

Specifically, both the first region and the second region are arranged on the same surface of the silicon substrate, meaning that the two regions coexist on the same side surface, possibly adjacent to each other or distributed on the surface in a specific manner. Or, the first region and the second region are arranged on the two opposite sides of the silicon substrate respectively, that is, one region is located on a front surface of the silicon substrate, and the other region is located on a back surface of the silicon substrate.

### Embodiment 12

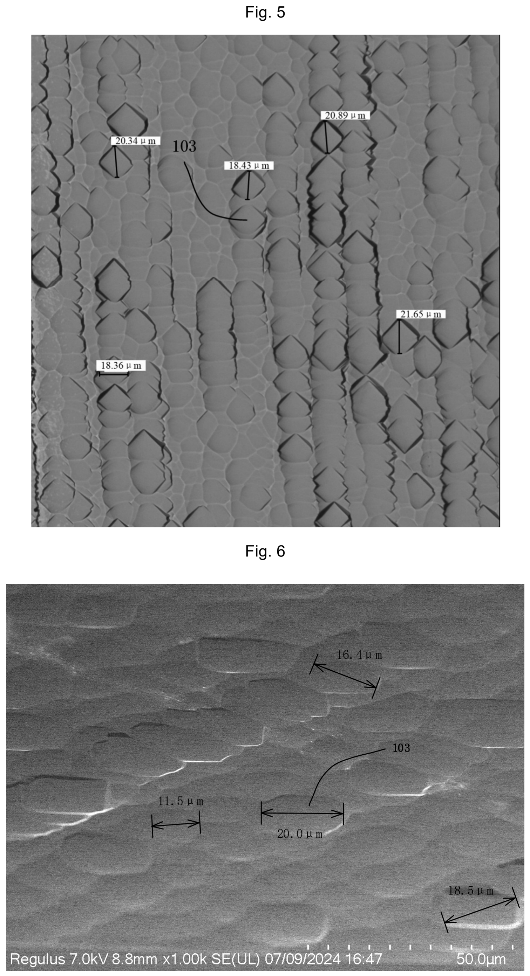

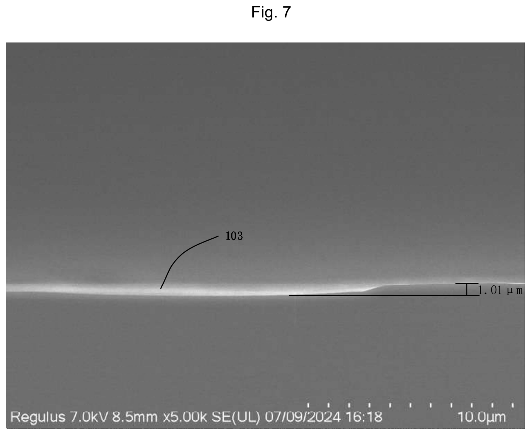

As shown in Fig. 5 to Fig. 7, based on Embodiment 11, the second region is provided with a plurality of third tower base structures 103, where Fig. 6 and Fig. 7 are scanning electron micrographs of the third tower base structures 103 at a first angle and a third angle respectively.

The arrangement of the third tower base structures 103 increases the complexity of the surface morphology of the second region, thereby allowing a passivation layer to cover the third tower base structures 103 more uniformly. The coverage can effectively reduce the surface density and recombination rate, thereby improving the passivation quality.

The third tower base structures 103 can also provide superior surface features, thereby allowing screen-printed metal paste to better fill spaces between the tower base structures when forming electrodes. The improved contact feature reduces the contact resistance between the electrode and the silicon substrate, thereby enhancing the open-circuit voltage and the fill factor of the cell.

The third tower base structures 103 may also be downward concave structures. It should be noted that taking the example of the third tower base structures 103 arranged on a surface of the second region of the silicon substrate, the downward concave structures may be understood as the third tower base structures 103 being downwards concave into the second region.

In some optional implementations, a depth of downward concavity of the third tower base structures is greater than or equal to 0.05 µm and less than or equal to 1.5 µm. Exemplarily, as shown in Fig. 6, the depth of the downward concavity of the third tower base structures 103 is 556 nm.

### Embodiment 13

Based on Embodiment 12, the longest diagonal length of the third tower base structures 103 is greater than or equal to 2 µm and less than or equal to 60 µm.

By further limiting the longest diagonal size of the third tower base structures 103, the tower base structures are optimized. The optimized tower base structures can not only effectively release stress and reduce mechanical damages but also further improve the passivation quality and electrode contact characteristics in the second region, thereby enhancing the open-circuit voltage and the fill factor, and finally improving the overall conversion efficiency of the cell.

### Embodiment 14

Based on Embodiment 13, the longest diagonal length of the third tower base structures 103 is greater than or equal to 5 µm and less than or equal to 40 µm.

By further limiting the longest diagonal size of the third tower base structures 103, the tower base structures are optimized. The optimized tower base structures can not only effectively release stress and reduce mechanical damages but also further improve the passivation quality and electrode contact characteristics in the second region, thereby enhancing the open-circuit voltage and the fill factor, and finally improving the overall conversion efficiency of the cell.

### Embodiment 15

Based on Embodiment 13, the longest diagonal length of the third tower base structures 103 is greater than or equal to 10 µm and less than or equal to 30 µm.

By further limiting the longest diagonal size of the third tower base structures 103, the tower base structures are optimized. The optimized tower base structures can not only effectively release stress and reduce mechanical damages but also further improve the passivation quality and electrode contact characteristics in the second region, thereby enhancing the open-circuit voltage and the fill factor, and finally improving the overall conversion efficiency of the cell.

### Embodiment 16

Based on Embodiment 13, the longest diagonal length of the third tower base structures 103 is greater than or equal to 15 µm and less than or equal to 30 µm.

By further limiting the longest diagonal size of the third tower base structures 103, the tower base structures are optimized. The optimized tower base structures can not only effectively release stress and reduce mechanical damages but also further improve the passivation quality and electrode contact characteristics in the second region, thereby enhancing the open-circuit voltage and the fill factor, and finally improving the overall conversion efficiency of the cell.

### Embodiment 17

Based on Embodiment 1, the longest diagonal length of the first tower base structures 101 is greater than the longest diagonal length of the second tower base structures 102.

The longest diagonal length of the first tower base structures 101 is greater than the longest diagonal length of the second tower base structure 102, meaning that within the tower base structures, the size of the first tower base structures 101 is greater than that of the second tower base structures 102. The larger first tower base structures 101 facilitate in distributing stress on the silicon substrate, thereby reducing the stress concentration phenomena. The smaller second tower base structures 102 can better adapt to changes in surface morphology, thereby reducing the risk of mechanical damages. Meanwhile, the larger first tower base structures 101 provide a larger coverage area for the passivation layer, thereby improving the passivation quality. The smaller second tower base structures 102 may make better contact the electrode, thereby reducing the contact resistance and enhancing the open-circuit voltage and the fill factor of the cell.

### Embodiment 18

Based on Embodiment 13, a ratio of the longest diagonal length of the first tower base structures 101 to the longest diagonal length of the third tower base structures 103 ranges from 0.5 to 2.

The longest diagonal length of the third tower base structures 103 may be greater than or equal to 0.5 times of the longest diagonal length of the first tower base structures 101, and less than or equal to 2 times of the longest diagonal length of the first tower base structures 101. The design specifies a specific proportional relationship between the longest diagonal lengths of the first tower base structures 101 and the third tower base structures 103 to ensure that the tower base structures in the two regions can work together cooperatively while leveraging respective advantages.

### Embodiment 19

Based on Embodiment 12, the roughness of the first region is greater than that of the second region.

Surface roughness refers to a degree of microscopic irregularity on the surface, with higher roughness indicating more microscopic protrusions or depressions on the surface. The high surface roughness of the first region means that the surface of the region is more irregular, with more microstructures. The low surface roughness of the second region indicates a relatively smooth and flat surface.

The differential design in surface roughness can effectively improve photoelectric conversion efficiency, optimize electrode contact characteristics, reduce surface composition effects, and contribute to enhancement on mechanical performance.

### Embodiment 20

As shown in Fig. 1, based on Embodiment 1, the plurality of first tower base structures 101 are in a linear array.

The plurality of first tower base structures 101 are arranged in the regular linear array within the first region. That is, the first tower base structures 101 are arranged in a certain direction with a certain spacing and regularity, thereby forming a neat linear structure. The linear array arrangement of the first tower base structures 101 may be determined according to design requirements, including parameters such as a spacing, an arrangement direction, and a density of the array, to achieve optimal performance.

Through the arrangement method, the stress can be uniformly distributed, the simplicity and consistency of the manufacturing process are improved, and the overall performance and reliability of the solar cell are further optimized.

### Embodiment 21

As shown in Fig. 5, based on Embodiment 1, the plurality of third tower base structures 101 are in a linear array.

The plurality of third tower base structures 103 are arranged in the regular linear array within the second region. That is, the first tower base structures 103 are arranged in a certain direction with a certain spacing and regularity, thereby forming a neat linear structure. The linear array arrangement of the third tower base structures 103 may be determined according to design requirements, including parameters such as a spacing, an arrangement direction, and a density of the array, to achieve optimal performance.

Through the arrangement method, the stress can be uniformly distributed, the simplicity and consistency of the manufacturing process are improved, and the overall performance and reliability of the solar cell are further optimized.

### Embodiment 22

Based on Embodiment 1 and Embodiment 12, the first tower base structures 101 and/or the second tower base structures 102 are downward concave structures. That is, the first tower base structures 101 and/or the second tower base structures 102 have downward concave portions.

Specifically, the first tower base structures 101 and the second tower base structures 102 are concave, or one of the first tower base structures 101 and the second tower base structures 102 is concave.

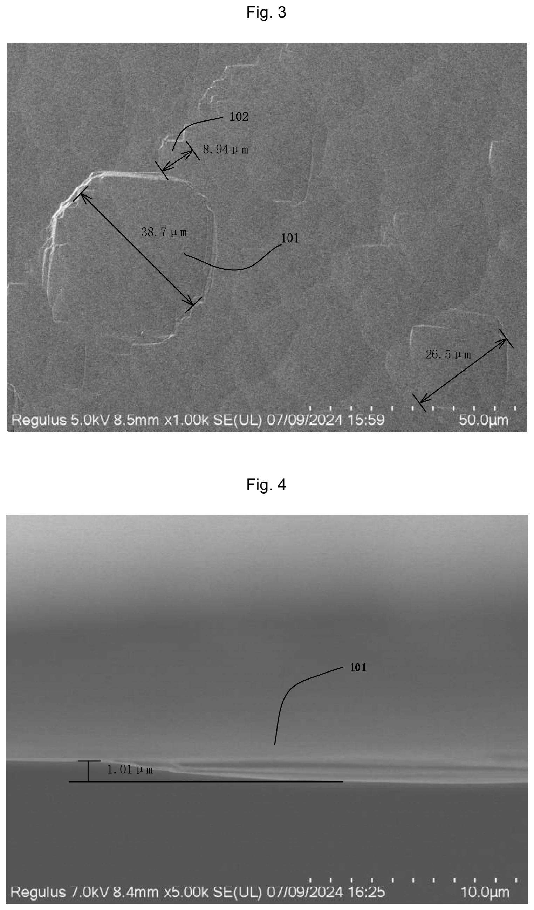

As shown in Fig. 4, the first tower base structures 101 are downward concave structures. It should be noted that taking the example of the first tower base structures 101 arranged on a surface of the first region of the silicon substrate, the above downward concave structures may be understood as the first tower base structures 101 being downwards concave into the first region.

In some optional implementations, a depth of downward concavity of the first tower base structures and/or the second tower base structures is greater than or equal to 0.05 µm and less than or equal to 2 µm. Exemplarily, as shown in Fig. 4, the depth of the downward concavity of the first tower base structures 101 is 1.01 nm.

### Embodiment 23

This embodiment provides a cell assembly, including the solar cell according to any one of the above embodiments.

The beneficial effects obtained by the cell assembly in this embodiment are similar to those of the solar cell, which are not repeated herein.

### Embodiment 24

This embodiment provides a photovoltaic system, including the cell assembly in Embodiment 23.

The beneficial effects obtained by the photovoltaic system in this embodiment are similar to those of the solar cell, which are not repeated herein.

The foregoing descriptions are merely preferred embodiments of the present disclosure, but are not intended to limit the present disclosure. Any modification, equivalent substitution, improvement, etc. made within the spirit and principle of the present disclosure shall fall within the scope of protection of the present disclosure.

## Claims

1. A solar cell, comprising:
a silicon substrate, which comprises a first region,
the first region being provided with a plurality of first tower base structures and a plurality of second tower base structures, with at least some of the second tower base structures arranged on the first tower base structures.

2. The solar cell according to claim 1, wherein
a longest diagonal length of the first tower base structures is greater than or equal to 2 µm and less than or equal to 60 µm; or
a longest diagonal length of the first tower base structures is greater than or equal to 5 µm and less than or equal to 40 µm; or
a longest diagonal length of the first tower base structures is greater than or equal to 10 µm and less than or equal to 30 µm; or
a longest diagonal length of the first tower base structures is greater than or equal to 15 µm and less than or equal to 30 µm.

3. The solar cell according to claim 1, wherein
a longest diagonal length of the second tower base structures is greater than or equal to 0.5 µm and less than or equal to 30 µm; or
a longest diagonal length of the second tower base structures is greater than or equal to 1 µm and less than or equal to 30 µm; or
a longest diagonal length of the second tower base structures is greater than or equal to 1 µm and less than or equal to 20 µm; or
a longest diagonal length of the second tower base structures is greater than or equal to 5 µm and less than or equal to 20 µm.

4. The solar cell according to claim 2 or 3, wherein a ratio of a total area of orthographic projections of the second tower base structures on the first region to an area of the first region is greater than 60%.

5. The solar cell according to claim 1, further comprising a second region, the second region and the first region being located on a same side of the silicon substrate or on two opposite sides of the silicon substrate.

6. The solar cell according to claim 5, wherein the second region is provided with a plurality of third tower base structures.

7. The solar cell according to claim 6, wherein
a longest diagonal length of the third tower base structures is greater than or equal to 2 µm and less than or equal to 60 µm; or
a longest diagonal length of the third tower base structures is greater than or equal to 5 µm and less than or equal to 40 µm; or
a longest diagonal length of the third tower base structures is greater than or equal to 10 µm and less than or equal to 30 µm.

8. The solar cell according to claim 1, wherein a longest diagonal length of the first tower base structures is greater than a longest diagonal length of the second tower base structures.

9. The solar cell according to claim 6, wherein a ratio of the longest diagonal length of the first tower base structures to a longest diagonal length of the third tower base structures ranges from 0.5 to 2.

10. The solar cell according to claim 5, wherein a roughness of the first region is greater than a roughness of the second region.

11. The solar cell according to claim 1, wherein the plurality of first tower base structures are in a linear array.

12. The solar cell according to claim 6, wherein the plurality of third tower base structures are in a linear array.

13. The solar cell according to claim 1, wherein the first tower base structures are downward concave structures, or the second tower base structures are downward concave structures, or wherein the first tower base structures and the second tower base structures are downward concave structures.

14. The solar cell according to claim 13, wherein a depth of downward concavity of the first tower base structures is greater than or equal to 0.05 µm and less than or equal to 2 µm, or a depth of downward concavity of the second tower base structures is greater than or equal to 0.05 µm and less than or equal to 2 µm, or a depth of downward concavity of the first tower base structures and a depth of downward concavity of the second tower base structures are greater than or equal to 0.05 µm and less than or equal to 2 µm.

15. The solar cell according to claim 6, wherein the third tower base structures are downward concave structures.

16. The solar cell according to claim 15, wherein a depth of downward concavity of the third tower base structures is greater than or equal to 0.05 µm and less than or equal to 1.5 µm.

17. A cell assembly, comprising the solar cell according to any one of claims 1 to 16.

18. A photovoltaic system, comprising the cell assembly according to claim 17.
